## Europäisches Patentamt
## European Patent Office
## Office européen des brevets

(19)

(11) Veröffentlichungsnummer: **0 006 466**
**B1**

(12) **EUROPÄISCHE PATENTSCHRIFT**

(45) Veröffentlichungstag der Patentschrift: **26.05.82**

(51) Int. Cl.³: **G 11 C 19/28,**
**G 11 C 27/02**

(21) Anmeldenummer: **79101692.6**

(22) Anmeldetag: **01.06.79**

(54) **Ladungsverschiebungseinrichtung und Verfahren zum Betrieb dieser Einrichtung.**

(30) Priorität: **30.06.78 US 920922**

(43) Veröffentlichungstag der Anmeldung:
**09.01.80 Patentblatt 80/1**

(45) Bekanntmachung des Hinweises auf die Patenterteilung:
**26.05.82 Patentblatt 82/21**

(84) Benannte Vertragsstaaten:
**DE FR GB**

(73) Patentinhaber: **International Business Machines
Corporation
Armonk, N.Y. 10504 (US)**

(72) Erfinder: **Aichelmann, Jr., Frederick John
RD. No. 7, Taconic Drive
Hopewell Jct., NY 12533 (US)**

(74) Vertreter: **Lewit, Leonard, Dipl.-Ing.
Schönaicher Strasse 220
D-7030 Böblingen (DE)**

(56) Entgegenhaltungen:
DE - A - 2 516 692
DE - A - 2 518 017
DE - A - 2 526 244
US - A - 3 760 202
US - A - 3 789 247
US - A - 3 891 977
US - A - 3 913 077
US - A - 3 914 748
US - A - 3 965 462
US - A - 3 967 254
US - A - 3 975 717
US - A - 4 007 446
US - A - 4 092 734

(56) Entgegenhaltungen:
IBM TECHNICAL DISCLOSURE BULLETIN, Vol.
21, Nr. 9, Februar 1979, Armonk, US,
AICHELMANN: "Dual SPS organization with
recirculation for page access" Seiten 3649—
3650
IEEE JOURNAL OF SOLID STATE CIRCUITS, Vol.
SC9, Nr. 6, Dezember 1974, New York, US,
KRAMBECK et al.: "A 4160 bit C4D serial
memory", Seiten 436—443
IEEE JOURNAL OF SOLID STATE CIRCUITS, Vol.
SC11, Nr. 1, Februar 1976, New York,
CHOU: "Design of a 16,384 bit serial charge-
coupled memory device", Seiten 10—18

EP 0 006 466 B1

## Ladungsverschiebungseinrichtung und Verfahren zum Betrieb dieser Einrichtung

Die Erfindung bezieht sich auf eine Ladungsverschiebungseinrichtung mit zwei seriellen Eingangs- und Ausgangsregistern und einem parallelen Verschiebungsteil.

Solche Ladungsverschiebungseinrichtungen können in vielfältiger Weise verwendet werden. Sie eignen sich als Analg-Schieberegister, als elektronisch steuerbare Analog-Verzögerungsleitungen, zur Bildabstastung, zur Durchführung von Autokorrelationen und schließlich als digitale Speicher.

In der oben angegebenen Struktur mit einem seriellen Eingangsteil, einem parallelen Verschiebungsteil und einem seriellen Ausgangsteil (SPS-Struktur) kann bei der Verwendung als digitaler Speicher ein Datenbitstrom in das erste Register eingeschoben werden und nach Beendigung dieser Eingabeoperation in den parallelen Verschiebungsteil übernommen werden. In dem aus einzelnen Kanälen bestehenden parallelen Verschiebungsteil wird nun das eingelesene Datenbyte oder Datenwort parallel zum zweiten Register hin verschoben, von wo es seriell ausgelesen werden kann. Diese Anordnung ist jedoch Beschränkungen dadurch unterworfen, daß Ladungsverschiebungseinrichtungen pro Bit jeweils eine Übertragungs- und eine Speicherstelle benötigen. Bei Verwendung einer Zweiphasen-Taktsteuerung werden die Bit jeweils von einer Speicherstelle zu einer Übertragungsstelle verschoben und hiernach mit dem Taktpulszug der anderen Phase von der Übertratungsstelle zur nächsten Speicherstelle. Hierdurch ist von den gespeicherten Datenbits jeweils nur eine Hälfte der Einrichtung belegt. Weisen die beiden seriellen Register z. B. acht Stellen auf, so können in jedem der beiden Register jeweils nur vier Bits gespeichert werden. Auch der parallele Teil ist in ähnlicher Weise Beschränkungen unterworfen, da in der integrierten Halbleiterstruktur die Breite eines Kanales doppelt so ist wie die Breite einer einzelnen Stelle in den seriellen Registern. Durch diese schlechte Platzausnutzung wird die Erzielung einer hohen Bitdichte verhindert.

Zur Erhöhung der möglichen Bitdichte kann die beschriebene SPS-Struktur in verzahnter Weise ausgeführt werden, Hierdurch ist es im oben genannten Beispiel möglich, alle acht Bits parallel durch den parallelen Verschiebungsteil zu übertragen. Eine solche verzahnte Ladungsverschiebungseinrichtung ist z. B. in der US—PS 3 913 077 beschrieben.

Obwohl digitale Ladungsverschiebungsspeicher einfacher und daher billiger zu erzeugen sind als andere Speicher mit wahlfreiem Zugriff, steht ihrer Verwendung doch der Nachteil entgegen, daß sie im wesentlichen seriell und daher langsam arbeiten. Die Arbeitsgeschwindigkeit von Ladungsverschiebungsspeichern wird vielfach noch dadurch herabgesetzt, daß ein Datenbit nur jeweils beim übernächsten Taktpuls ein oder ausgegeben wird. Bei einer möglichen Taktpulsfrequenz von 2 MHz beträgt die Datenübertragungsrate also nur 1 MHz.

Auch durch eine Erhöhung der Taktpulsfrequenz kann die Geschwindigkeit der Einrichtung nicht erhöht werden, da dies durch die vorhandenen Kapazitäten einen erhöhten Leistungsverbrauch und dadurch eine erhöhte Erwärmung zur Folge hätte.

Wohl ist aus dem in der Zeitschrift IEEE Journal of Solid-State Circuits, Vol. SC-9, No. 6, Dezember 1974, Seiten 436 bis 443 erschienenen Artikel eine aus zwei Hälften bestehende zweiphasige Ladungsverschiebungseinrichtung bekannt geworden, die es gestattet, pro Phasentaktsignal ein Datenbit in eine der Hälften ein- oder auszugeben. Die genannte Einrichtung hat keine SPS-Struktur und ist insofern nachteilig, als in der Mitte der zwischen den beiden Serienregistern liegenden Kanallänge zwei Reihen von Regeneratoren vorgesehen werden müssen.

Ferner ist aus der DE—OS 25 18 017 ein CCD-Speicher mit SPS-Struktur bekannt geworden, in dem jeweils benachbarte Ladungsverschiebungselemente des Eingangs- und Ausgangs-Serienregisters von jeweils zwei verschiedenen Phasen angesteuert werden und mit jeweils einem Kanal des Parallelteiles des Speichers verbunden sind. Der gesamte Speicher weist dabei zwei SPS-Strukturen mit zueinander entgegengestzter Richtung der Parallelverschiebung auf, wobei das Ausgangsregister der einen Struktur jeweils mit dem Eingangsregister der anderen Struktur verbunden ist und damit ein geschlossener Regenerierungskreis möglich wird. In einer der beiden Verbindungen zwischen Eingangs- und Ausgangskette ist der Regenerierer zugleich als Dateneingabe- und ausgabeschaltung ausgeführt. Die beschriebene Einrichtung gestattet eine Erhöhung der Speicherdichte innerhalb des Parallelteiles, doch bleibt die Arbeitsgeschwindigkeit relativ langsam.

Schließich ist in der US—PS 3 975 717 ein CCD-Speicher beschrieben, der in jeweils benachbarten Schieberegistern der Speicher-Schieberegisterkette eine entgegengesetzte Verschieberichtung aufweist. Der Aufbau einer SPS-Struktur ist mit der gezeigten Einrichtung jedoch nichtmöglich.

Der vorliegenden Erfindung leigt daher die Aufgabe zugrunde, in einer Ladungsverschiebungseinrichtung der eingangs beschriebenen Art die Funktionsgeschwindigkeit der Einrichtung zu erhöhen.

Die Lösung dieser Aufgabe ist im Patentanspruch 1 gekennzeichnet.

Mit der Erfindung wird erreicht, daß bei Verwendung der Einrichtung z. B. als digitaler Speicher bei *jedem* Taktimpuls, und nicht bei jedem zweiten, ein Datenbit ein- bzw ausgegeben werden kann. Die Erhöhung der Geschwindigkeit beruht darauf, daß zugleich die Datenbits vom einen Register in einer Richtung durch den parallelen Teil verschoben werden und vom anderen Register in der entgegengesetzten Richtung verschoben werden. Die Bit-übertratungsrate wird hierdurch annähernd verdoppelt.

Die beiden Serienregister der erfindungsgemäßen SPS-Struktur können also sowohl Ladungen vom Parallelteil aufnehmen als auch Ladungen an den Parallelteil abgeben. Dadurch, daß beide Register jeweils mit einem Eingang und einem Ausgang versehen sind, können die beiden Serienregister sowohl als Eingangs- als auch als Ausgangsregister verwendet werden. Insgesamt ergibt sich durch die Erfindung eine sehr komprimierte SPS-Struktur, welche eine Arbeitsweise mit hoher Geschwindigkeit gestattet.

Zur Erzielung einer geschlossenen Speicherschleife kann jeweils der Ausgang eines der beiden Serienregister über einen Regenerator mit dem Eingang des anderen Serienregisters verbunden werden. In die beiden Regeneratoren können dabie die Datenbits eingegeben oder von diesen Regeneratoren ausgelesen werden.

An dieser Stelle soll darauf hingewiesen werden, daß aus der US—PS 3 965 462 ein bidirektioneller paralleler Verschiebungsteil in einer Ladungsverschiebungseinrichtung bekanntgeworden ist. In dieser Einrichtung gehören zwei benachbarte Kanäle, in denen die Ladungen in entgegengesetzter Richtung verschoben werden, zu zwei verschiedenen Verschiebungsfeldern. Es wird mit der bekannten Einrichtung nicht eine Erhöhung der Funktionsgeschwindigkeit, sondern die Erzielung von Platzerweiterungen für Regenerator-und Phase-numkehrschaltungen bezweckt. In dieser Einrich-tung werden außerdem keine Register verwendet, die sowohl zur Eingabe als auch zur Ausgabe verwendet werden.

Vorteilhafte Weiterbildungen der Erfindung sind den Unteransprüchen zu entnehmen.

Im folgenden wird die Erfindung von lediglich einen Ausführungsweg darstellenden Zeichnungen näher erläutert.

Es zeigt:

Fig. 1 die schematische Darstellung einer bildirektionellen Ladungsverschiebungseinrichtung mit einer seriell-parallel-seriell Struktur.

Fig. 2 die seriellen Teile und den parallelen Teil der Ladungsverschiebungseinrichtung sowie die strichliert gezeichneten Datenpfade,

Fign. 3 bis 14 die Verschiebung der Datenbits in der Einrichtung durch die seriellen Teile und den parallelen Teil und

Fig. 15 Taktpulszüge zur Steuerung der in den Fign. 3 bis 14 gezeichneten Einrichtungen sowie ein Wechselintervall.

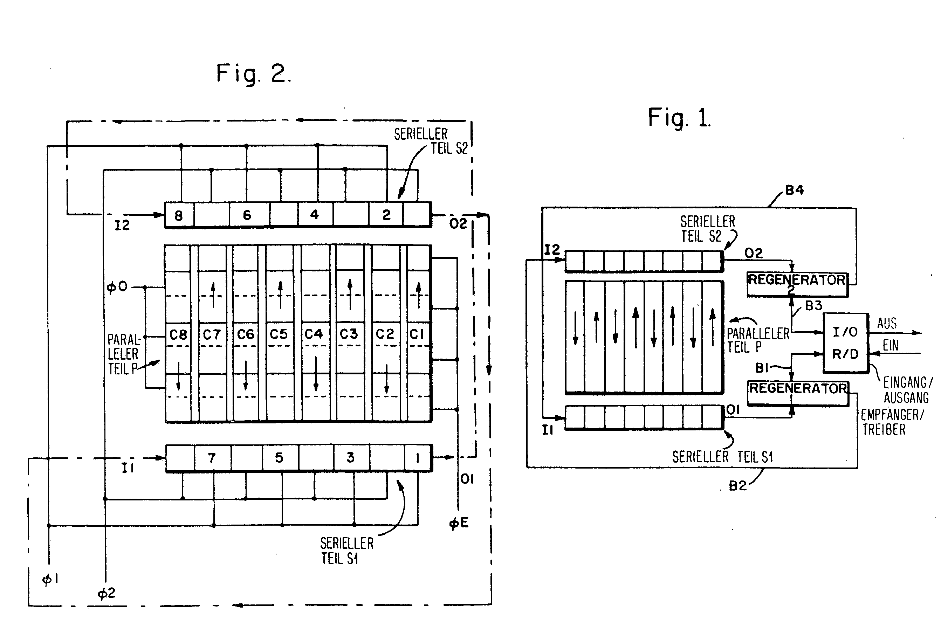

In Fig. 1 ist eine Ladungsverschiebungseinrichtung mit einem Parallelteil P gezeigt, der zwischen einem ersten seriellen Teil S1 und einem zweiten seriellen Teil S2 liegt. Zum Unterschied gegenüber den bekannten derartigen seriell-parallel-seriell (SPS) Strukturen wird in der in Fig. 1 gezeigten Einrichtung sowohl der erste als auch der zweite serielle Teil S1 und S2 als Eingangs- und Ausgangsteil benutzt. In die erste Stufe jedes der beiden seriellen Teile, d. h. jedes der beiden Schieberegister S1 und S2 können also Ladungen, wie z. B. Datenbit eingegeben und von der letzten Stufe der Register ausgelesen werden. Auch der parallele Teil P unterscheidet sich von den bekannten parallelen Verschiebungsteilen dadurch, daß er bidirektionell arbeitet, wie in Fig. 1 durch Pfeile angedeutet ist. Der parallele Teil P besteht aus einer Matrix von Speicherstellen zur Speicherung von Ladungspaketen, die vertikale Spalten bilden, d. h. Kanäle, die sich zwischen den beiden seriellen Teilen S1 und S2 erstrecken. Im ersten, dritten, usw. Kanal weist die Ladungsverschiebungsrichtung in Fig. 1 nach abwärts, d. h. vom Register S2 zum Register S1 und im zweiten, vierten, usw. Kanal aufwärts vom Register S1 zum Register S2.

Am Ausgang der letzten Stufe des ersten Registers S1 ist eine Ausgangsleitung 01 vorgesehen, auf der Datenbits zu einem Regenerator 1 übertragen werden können. Vom Regenerator können die Datenbits über eine bidirektionelle Sammelleitung B1 zu einer Eingangs-/Ausgangsdateneinrichtung I/O übertragen werden. Über diese Dateneinrichtung können Datenbits über Empfänger (R) ein- oder über Treiber (D) ausgelesen werden.

In einer anderen Betriebsweise können die Datenbits vom Regenerator 1 über die Sammel-leitung B2 zum Eingang I2 des zweiten Re-gisters S2 übertragen werden. Nach dem seriellen Einschieben der Datenbits in das Register S2 werden die in der Form von diskreten Ladungspaketen gegebenen Datenbits parallel in dem Verschiebungsteil P übernommen. Die Übernahme erfolgt dabei in die Kanäle, die in Fig. 1 einen abwärts gerichteten Teil aufweisen. Daraufhin wird die eingelesene Datenzeile parallel nach abwärts verschoben und schließlich in das erste Register S1 eingelesen, von wo die Datenbits seriell über den Regenerator 1 wieder in das zweite Register S2 eingeschoben werden können und damit der Regenerationszyklus wiederholt werden kann.

In ähnlicher Weise können die Ladungspakete vom zweiten Register ausgelesen und über die Leitung O2 zum Regenerator 2 über-tragen werden. Von dort können sie entweder über die bidirektionelle Sammelleitung B3 und die Dateneinrichtung I/O ausgelesen oder über die Sammelleitung B4 zum Eingang I1 des ersten Registers S1 übertragen werden. Vom ersten Register werden die Datenbits parallel in die unterste Zeile des parallelen Verschiebungsteils P übernommen und in weiteren Taktpulszyklen nach oben verschoben, bis sie schließlich im zweiten Register S2 landen und der Regenerationszyklus widerholt werden kann.

In Fig. 2 ist die SPS-Struktur der Einrichtung genauer gezeigt. Die Datenpfade sind strichliert angedeutet und es ist die Steuerung der Einrichtung durch vier Taktpulszüge gezeigt. Auch die Fig. 2 zeigt, wie die Daten über den Ausgang O2 des Registers S2 regeneriert und zum Eingang I1 des ersten Registers S1 übertragen werden können. In ähnlicher Weise können die Datenbits vom Ausgang O1 des ersten Registers S1 ausgelesen, regeneriert und zum Eingang I2 des zweiten Registers S2 übertragen werden.

Der Übersichtlichkeit wegen sind in Fig. 2 nur acht Kanäle C1 bis C8 des parallelen Verschiebungsteiles P gezeigt. Der Datenfluß in den ungeradzahligen Kanälen erfolgt von unten nach oben und in den geradzahligen Kanälen von oben nach unten. Fig. 2 zeigt auch die Stellen in den beiden Registern S1 und S2, die von den acht Bits eines Datenbytes ursprünglich eingenommen werden können.

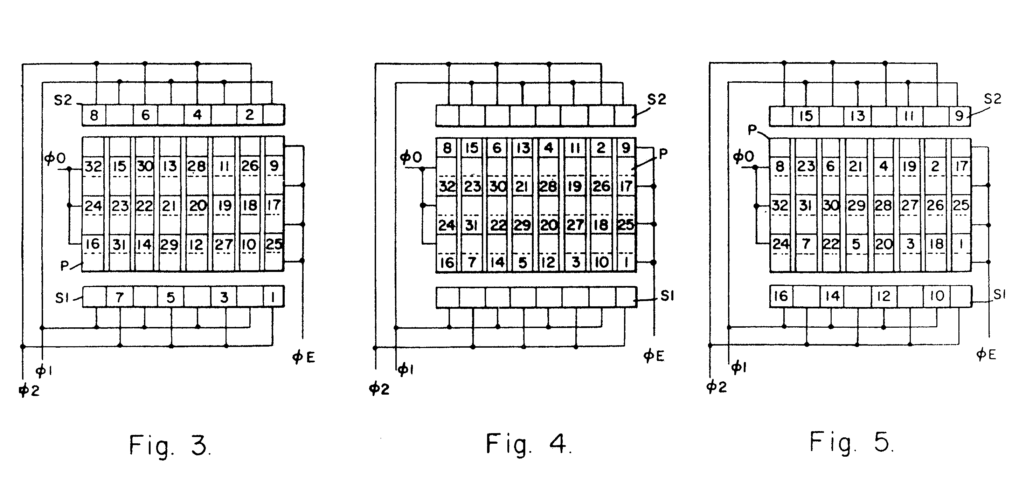

In den Fign. 3 bis 14 ist gezeigt, wie der bidirektionelle und verzahnte Fluß der Datenbits Schritt für Schritt abläuft. In Fig. 3 ist gezeigt, wie die Bits in aufeinanderfolgenden, ungeradzahligen Bitpositionen in den ersten seriellen Teil S1 der Ladungsverschiebungseinrichtung eingeschoben werden und wie die Datenbits in aufeinanderfolgenden geradzahligen Bitpositionen nach dem Einschieben im zweiten Register S2 gespeichert sind. In Fig. 3 sind auch die Datenbits angedeutet, welche sich bereits im parallelen Verschiebungsteil P befinden.

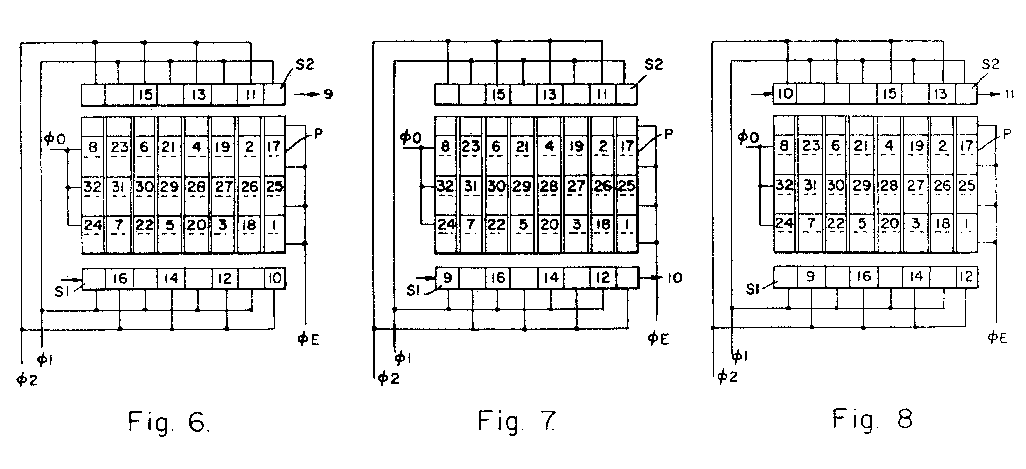

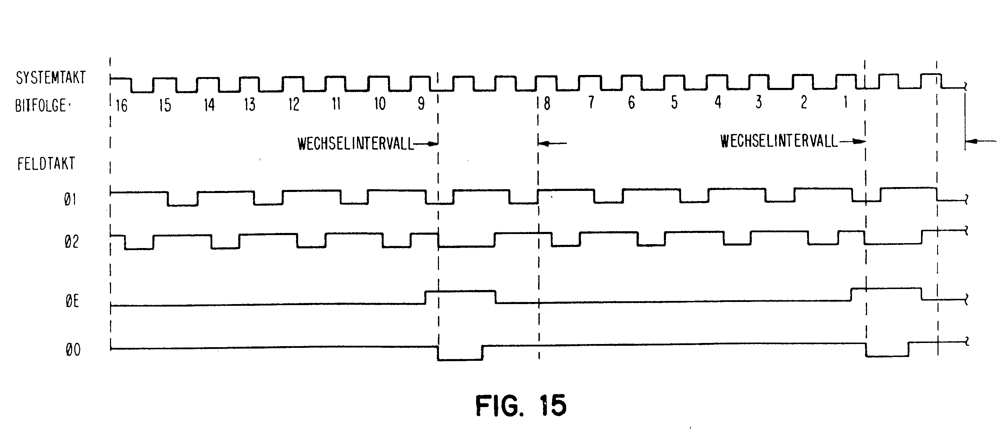

Fig. 15 zeigt den Feldtakt, d. h. die in der Einrichtung verwendeten Taktpulszüge sowie den Systemtakt- und die Bitsequenz. Dabei wird angenommen, daß bei der in Fig. 3 gezeigten Anordnung der Datenbits ein sogenanntes Wechselintervall eintritt. In diesem Zeitintervall werden die seriell in die beiden Register S1 und S2 eingeschobenen Daten parallel in den Verschiebungsteil P übernommen. Während dieser Serien-Parallel-Umsetzung erfolgt keine Dateneingabe in die oder aus der Einrichtung. Die Fign. 4, 5 und 6 beziehen sich auf dieses Wechselintervall, d. h. auf die Übertragung von Daten zwischen den seriellen und dem parallelen Teil der Einrichtung, während die Fign. 7 bis 14 sich auf die externe Rezirkulation der Daten, bzw. auf die Datenein- oder -ausgabe beziehen.

Aus Fig. 4 ist ersichtlich, daß nach dem Anliegen des Taktpulses ØE die ungeradzahligen Datenbits 1, 3, 5 und 7 parallel in die unterste Reihe der Verschiebungsmatrix, die den parallelen Verschiebungsteil P bildet, übernommen werden. Zur gleichen Zeit werden die geradzahligen Datenbits 2, 4, 6 und 8 vom zweiten seriellen Teil S2 parallel nach unten in die oberste Reihe des Verschiebungsteiles P übertragen. Die Bits innerhalb der Verschiebematrix werden auch in neue Speicherstellen geschoben, wie in Fig. 4 dargestellt ist. Die geradzahligen Datenbits werden in die geradzahligen Kanäle C2, C4, C6 und C8 übernommen, in denen sie nach unten verschoben werden, während die ungeradzahligen Datenbits in die ungeradzahligen Kanäle C1, C3, C5 und C7 übernommen werden, welche gemäß den in Fig. 1 dargestellten Pfeilen eine aufwärts gerichtete Verschiebungsrichtung haben.

Fig. 5 zeigt, daß durch den Takpuls Ø0 die Ladungspakete im parallelen Teil P vertikal zur benachbarten Speicherstelle verschoben werden. Die Verschiebungsrichtung ist dabei in den geradzahligen Kanälen abwärts und in den ungeradzahligen Kanälen aufwärts gerichtet. Durch den Taktpuls Ø1 werden außerdem die Bit 10, 12, 14 und 16 parallel von der untersten Reihe des Verschiebungsteiles P in das erste Register S1 übernommen. Zugleich werden durch den Taktpuls Ø1 die Bits 9, 11, 13 und 15 parallel von der obersten Reihe in das zweite Register S2 übertragen.

In Fig. 6 ist gezeigt, wie durch abwechselnde Taktpulse Ø1 und Ø2 die Datenbits 9, 11, 13 und 15 seriell durch das zweite Register S2 zum Ausgang dieses Registers geschoben werden. Diese Bits können dann wie beschrieben ausgegeben oder zum Eingang des ersten Registers S1 übertragen werden. Dies ist in Fig. 7 dargestellt, wo das Bits 9 bereits zur ersten Speicherstelle des ersten Registers S1 übertragen wurde.

In ähnlicher Weise werden die Bits 10, 12, 14 und 16 seriell durch das erste Register S1 geschoben (siehe Fig. 7) und können von dort zur Ausgabe-Dateneinrichtung oder zum Eingang des zweiten Registers S2 übertragen werden. Diese letztere Alternative ist in Fig. 8 gezeigt, wo das Bit 10 bereits zur ersten Speicherstelle des zweiten Registers S2 übertragen wurde.

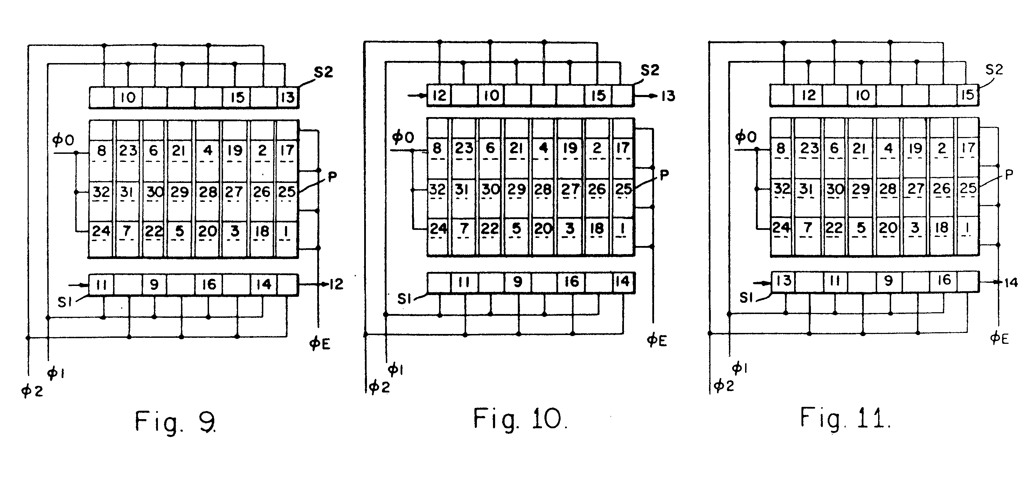

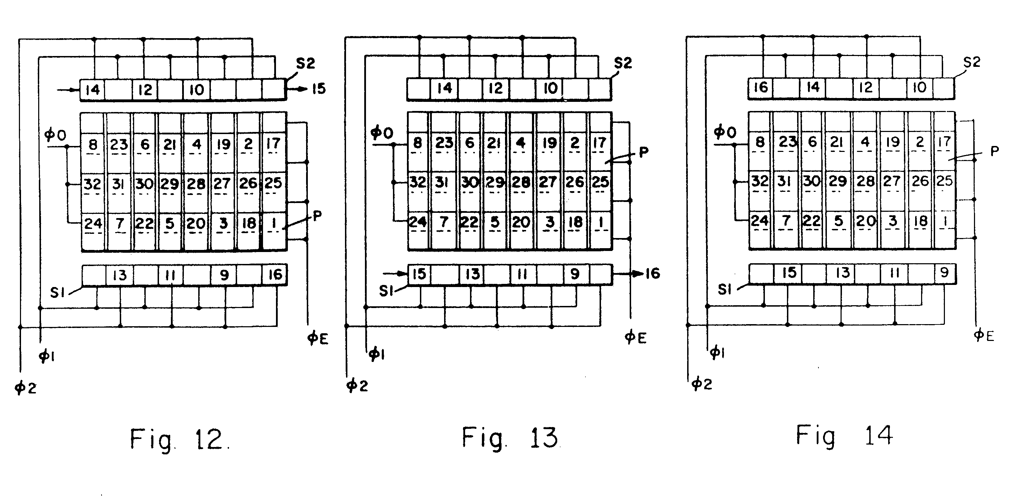

Aus den Fign. 9 bis 14 ist ersichtlich, wie durch aufeinanderfolgende Taktpulse Ø1 und Ø2 die Bits 9, 11, 13 und 15 aus dem zweiten Register S2 herausgeschoben und in das erste Register S1 eingeschoben werden, während die Bitfolge 10, 12, 14 und 16 seriell aus dem ersten Register S1 heraus und in das zweite Register S2 hineingeschoben wird. Die aufeinanderfolgenden Schritte dieser Verschiebeoperation sind in den Fign. 10 bis 13 dargestellt, während die endgültige Position der Datenbits nach der Verschiebung in Fig. 14 dargestellt ist.

Durch den Taktpuls ØE werden hierauf die Bits 10, 12, 14 und 16 in jeweils übernächste Speicherpositionen der obersten Zeile des Verschiebungsteiles P übernommen, während zugleich die Bits 9, 11, 13 und 15 in jeweils übernächste Speicherstellen in der untersten Zeile des parallelen Verschiebungsteiles P übernommen werden. Dies erfolgt in ähnlicher Weise wie bereits im Zusammenhang mit der Übertragung gemäß den Fign. 3 und 4 beschrieben wurde. Es ist ersichtlich, daß durch kontinuierliche Ansteuerung der Einrichtung

durch die Taktpulse Ø1, Ø2 und ØE schließlich alle Datenbits zu ihren in Fig. 3 gezeigten Ausganspositionen zurückverschoben werden, wenn die Einrichtung in der Regenerations-Betriebsweise arbeitet.

Aus der beschriebenen Funktionsweise geht also hervor, daß ungeradzahlige Datenbits in einer ersten Richtung durch den parallelen Verschiebungsteil P der Ladungsverschiebungseinrichtung verschoben werden, während zugleich die geradzahligen Datenbits in umgekehrter Richtung durch den parallelen Verschiebungsteil verschoben werden. Die ungeradzahligen Bits werden zunächst in den ersten seriellen Teil der Einrichtung eingelesen, befinden sich jedoch schließlich nach der Verschiebung im zweiten seriellen Teil, während die geradzahligen Bits in den zweiten seriellen Teil eingeschoben werden und sich schließlich jedoch im ersten seriellen Teil befinden. Die ungeradzahligen Datenbits können dann vom zweiten seriellen Teil asugegeben oder in einer anderen Betriebsweise (Regenerations-Betriebsweise) zurück zum ersten seriellen Teil übertragen werden, um den beschriebenen Verschiebungszyklus zu wiederholen. In gleicher Weise können die geradzahligen Datenbit vom ersten seriellen Teil ausgegeben oder alternativ regeneriert und zurück zum zweiten seriellen Teil der Einrichtung übertragen werden, woraufhin der Verschiebezyklus wiederholt werden kann.

Bei jedem Taktpuls, mit Ausnahme des beschriebenen Wechselintervalls, kann also ein Datenbit entweder von der SPS-Struktur ausgegeben oder innerhalb der Einrichtung regeneriert werden. Gemäß der beschriebenen Zweiphasen-Steuerung können die ungeradzahligen Datenbits während der Taktpulse der Phase 1 ausgegeben oder regeneriert werden und die geradzahligen Datenbits während den dazwischenliegenden Taktpulsen der Phase 2 ausgegeben oder regeneriert werden. Während jedes Paares von Taktpulsen (Taktpulsphase 1 und Taktpulsphase 2) werden also zwei Datenbits übertragen, wodurch die Arbeitsgeschwindigkeit der Einrichtung annähernd doppelt so hoch wird, wie von Einrichtungen, in denen die seriellen Teile nur jeweils zur Ein- oder Ausgabe in oder aus dem parallelen Verschiebungsteil verwendet werden und in denen der parallele Verschiebungsteil nicht bidirektionell ausgeführt ist.

## Patentansprüche

1. Ladungsverschiebungseinrichtung mit einem ersten und zweiten Schieberegister, die jeweils von einem zweiphasigen Verschiebetakt angesteuert werden, und mit parallelen Schieberegistern, die jeweils zwischen zwei zugeordneten Stufen der ersten und zweiten Schieberegister liegen, dadurch gekennzeichnet, daß die Ladungen in benachbarten parallelen Schieberegistern (C1—C8) in zueinander entgegengesetzter Richtung verschiebbar sind, daß die von der ersten Taktphase (Ø1) angesteuerten Stufen des ersten (S1) und zweiten (S2) Schieberegisters mit der Eingangsstufe des zugeordneten parallelen Schieberegisters und die von der zweiten Taktphase (Ø2) angesteuerten Stufen des ersten und zweiten Schieberegisters mit der Ausgangsstufe des zugeordneten parallelen Schieberegisters verbunden sind, und daß beide Schieberegister (S1, S2) sowohl mit einem Serieneingang (I1, I2) als auch mit einem Serienausgang (O1, O2) für die Ladungen versehen sind, wobei die beiden Serieneingänge ebenso wie die beiden Serienausgänge verschiedenen Taktphasen (Ø1, Ø2) zugeordnet sind.

2. Einrichtung nach Anspruch 1, dadurch gekennzeichnet, daß die Ausgänge (O1, O2) der beiden Schieberegister (S1, S2) jeweils über einen Regenerator (1, 2) mit dem Eingang (I2, I1) des anderen Schieberegisters (S2, S1) verbunden sind und daß die beiden Regeneratoren jeweils über eine bidirektionelle Sammelleitung (B1, B3) mit einer Daten-Eingangs/Ausgangs-Schaltung (I/O) verbunden sind.

3. Verfahren zum Betrieb der Ladungsverschiebungseinrichtung nach den Ansprüchen 1 und 2, dadurch gekennzeichnet, daß in der Ladungsverschiebungseinrichtung digitale Datenbits gespeichert werden und daß vier Taktpulszüge (Ø1, Ø2, ØE, ØO, Fig. 15) verwendet werden, wobei zwei Taktpulszüge relativ hoher Frequenz (Ø1, Ø2) die Verschiebung in den beiden seriellen Registern (S1, S2) bewirken, wobei der dritte Taktpulszug (ØE) relativ niedriger Frequenz die Übernahme der Datenbits von den beiden Registern in den parallelen Verschiebungsteil (P) bewirkt und der vierte Taktpulszug (ØO) relativ niedriger Frequenz zusammen mit dem ersten Taktpulszug (Ø1) die Übernahme der Datenbits vom parallelen Verschiebungsteil in die beiden Register bewirkt.

4. Verfahren nach Anspruch 3, dadurch gekennzeichnet, daß die Impulse des dritten und vierten Taktpulszuges (ØE, ØO), ein Wechselintervall (Fig. 15) definieren, in dem nur eine parallele Übertragung von Datenbits zwischen dem parallelen Verschiebungsteil (P) und den beiden Registern (S1, S2), jedoch keine Ein- oder Ausgabe von Datenbits in die oder aus den beiden Registern stattfindet.

5. Verfahren nach Anspruch 3, dadurch gekennzeichnet, daß der dritte und der vierte Taktpulszug (ØE, ØO), eine Verschiebung im parallelen Teil (P) in jeweils entgegengesetzter Richtung in benachbarten Kanälen (z. B. C1 und C2) bewirken.

6. Verfahren nach Anspruch 3, dadurch gekennzeichnet, daß in das erste Schieberegister (S1) die Bits geradzahliger Bitstellen und in das zweite Schieberegister (S2) die Bits ungeradzahliger Bitstellen eingegeben werden.

## Claims

1. A charge-coupled device with a first and a second shift register which are each controlled by a two-phase shift clock, and with parallel shift registers arranged between two associated stages of the first and the second shift register, characterized in that the charges in adjacent parallel shift registers (C1—C8) are shiftable in opposite directions, that the stages of the first shift register (S1) and the second shift register (S2) controlled by the first clock phase (Ø1) are connected to the input stage of the associated parallel shift register and the stages of the first and the second shift register controlled by the second clock phase (Ø2) are connected to the output stage of the associated parallel shift register, and that both shift registers (S1, S2) are provided with a serial input (I1, I2) as well as a serial output (O1, O2) for the charges, the two serial inputs as well as the two serial outputs being associated with different clock phases (Ø1, Ø2).

2. The device according to claim 1, characterized in that each of the outputs (O1, O2) of the two shift registers (S1, S2) have a regenerator (1, 2) connected to the input (I2, I1) of the other shift register (S2, S1), and that each of the two regenerators have a bidirectional bus (B1, B3) connected to a data input/output circuit (I/O).

3. A method of operating the charge-coupled device according to claims 1 and 2, characterized in that digital data bits are stored in the charge-coupled device and that four clock pulse trains (Ø1, Ø2, ØE, ØO, Fig. 15) are used, two clock pulse trains of a relatively high frequency (Ø1, Ø2) effecting the shifting in the two serial registers (S1, S2), the third clock pulse train (ØE) of a relatively low frequency effecting the transfer of the data bits from the two registers to the parallel shift section (P) and the fourth clock pulse train (ØO) of a relatively low frequency together with the first lock pulse train Ø1) effecting the transfer of the data bits from the parallel shift section to the two registers.

4. The method according to claim 3, characterized in that the pulses of the third and the fourth clock pulse train (ØE, ØO) define a skip interval during which there is only a parallel transfer of data bits between the parallel shift section (P) and the two registers (S1, S2) but no input or output of data bits into or from the two registers.

5. The method according to claim 3, characterized in that the third and the fourth clock pulse train (ØE, ØO) effect a shift in the parallel section (P) in opposite directions in adjacent channels (e.g. C1 and C2).

6. The method according to claim 3, characterized in that the even bit positions are entered into the first shift register (S1) and the odd bit positions are entered into the second shift register (S2).

## Revendications

1. Dispositif de décalage de charge comportant un premier et un second registres à décalage, chacun étant adressé par une impulsion de chronologie de décalage à deux phases, et des registres à décalage parallèles situés entre deux étages associés des premier et second registres à décalage, caractérisé en ce que: les charges dans des registres à décalage parallèles adjacents (C1—C8) peuvent être décalées dans des directions opposées l'une par rapport à l'autre, en ce que les étages adressées par la première phase de chronologie (Ø1) des premier et second registres à décalage (S1, S2) sont connectés à l'étage d'entrée du registre à décalage parallèle associé, et les étages adressés par la seconde phase de chronologie (Ø2) des premier et second registres à décalage sont connectés à l'étage de sortie des registres à décalage parallèles associés, et en ce que les deux registres à décalage (S1, S2) comportent une entrée série (I1, I2) ainsi qu'une sortie série (O1, O2) pour les charges, les deux entrées série ainsi que les deux sorties série étant associées à différentes phases de chronologie (Ø1, Ø2).

2. Dispositif selon la revendication 1, caractérisé en ce que les sorties (O1, O2) de deux registres à décalage (S1, S2) sont connectées à travers un régénérateur (1, 2) à l'entrée (I2, I1) de l'autre registre à décalage (S2, S1) et en ce que les deux régénérateurs sont connectés à travers une ligne collective bidirectionnelle (B1, B3) à un circuit d'entrée/sortie de données (I/O).

3. Procédé pour le fonctionnement d'un dispositif de décalage de charge selon les revendications 1 et 2, caractérisé en ce que le dispositif de décalage de charge emmagasine des bits de données numériques, et en ce que quatre trains d'impulsions de chronologie (Ø1, Ø2, ØE, ØO, figure 15) sont utilisés, deux trains d'impulsions de chronologie d'une fréquence relativement élevée (Ø1, Ø2) entraînant le décalage dans les deux registres série (S1, S2) et le troisième train d'impulsions de chronologie (ØE), d'une fréquence relativement faible, entraînant le transfert des bits de données des deux registres dans la partie de décalage parallèle (P), le quatrième train d'impulsion de chronologie (ØO), d'une fréquence relativement faible, avec le premier train d'impulsion de chronologie (Ø1), entraînant le transfert des bits de données de la partie de décalage parallèle dans les deux registres.

4. Procédé selon la revendication 3, caractérisé en ce que les impulsions des troisième et quatrième trains d'impulsions de chronologie (ØE, ØO) définissent un intervalle de changement (figure 15) pendant lequel n'a lieu qu'un transfert parallèle de bits de données entre la partie de décalage parallèle (P) et les deux registres (S1, S2) mais aucune entrée ou sortie de bits de données n'a lieu dans les deux registres ou à partir de ceux-ci.

5. Procédé selon la revendication 3, caractérisé en ce que les troisième et quatrième trains d'impulsions de chronologie (ØE, ØO) provoquent un décalage dans la partie parallèle (P) dans une direction opposée dans les canaux adjacents (par exemple C1 et C2).

6. Procédé selon la revendication 3, caractérisé en ce que les bits des positions de bits paires sont introduits dans le premier registre à décalage (S1) et les bits des positions de bits impaires sont introduits dans le second registre à décalage (S2).

Fig. 2.

Fig. 1.

Fig. 3.

Fig. 4.

Fig. 5.

2

Fig. 6.

Fig. 7

Fig. 8

0 006 466

Fig. 9.        Fig. 10.        Fig. 11.

Fig. 12.

Fig. 13

Fig 14

FIG. 15